# EUROPEAN PATENT APPLICATION

(11) **EP 1 515 219 A1**
(43) Date of publication of application: **16.03.2005**
(21) Application number: 03020408.5
(22) Date of filing: 10.09.2003
(51) Int. Cl.: G06F 1/18, E05B 65/00

(54) **Closing plate structure for the front cover of a computer case**

(71) Applicant: Lee, Kevin, Pa-The City, Tao-Yuan Hsien (TW)
(72) Inventor: Lee, Kevin, Pa-The City, Tao-Yuan Hsien (TW)
(74) Representative: VOSSIUS & PARTNER

(57) **Abstract**

A closing plate structure for a front cover (10) of a computer case is characterized in a closing plate (20) with two catches (21,22) provided at two rear lateral ends thereof, and one of the two catches is a U-shaped retaining strip having a free end forward projected from a front side of the closing plate (20). A user may operate the forward projected free end of the catch to directly remove or replace the closing plate from or to the front cover from a front side of the front cover, enabling easy installation and removal of peripherals into and out of the computer case.

## Description

The present invention relates to a closing plate structure for front cover of computer case, and more particularly to a closing plate structure that allows easy removal and replacement of a closing plate from and to the front cover of a computer case directly from a front side of the front cover.

A computer case for a desktop computer is typically provided at a front cover with a plurality of closing plates, which close a hollow space behind them for mounting some peripherals of the computer, such as hard disk, CD-ROM, portable storage device, etc.

With the quick developments in computer industry, peripherals for computer systems are constantly changed in their specifications to provide quicker writing and reading speed and increased storage capacity from time to time. When these peripherals are removed from the computer case, it is necessary to replace the closing plates to the front cover of the computer case, lest external dust or foreign matters should invade the computer case. In the case of using a portable storage medium that may be removed from a computer mainframe at any time, the times of removal and replacement of the closing plates are largely increased.

In a conventional closing plate structure, hooking ribs and recesses are provided on lateral walls of the closing plate and an opening on the front cover for locating the closing plate, so that the closing plate is fixed on the front cover in the opening. The hooking ribs and recesses are so configured that the closing plate could not be removed directly from a front side of the front cover. A user has to dismount the front cover from the computer case or even disassemble the whole computer case to disengage the closing plate from the front panel from a rear side thereof. In the case the closing plate has to be frequently removed and replaced, such as in the case of using a removable hard disk, it would be very inconvenient for the user to do so. It is therefore desirable to develop a closing plate that may be conveniently dismounted and replaced to facilitate installation and replacement of peripherals into the computer case.

A primary object of the present invention is to provide a closing plate structure for front cover of computer case to improve the conventional one that could not be easily dismounted from and replaced to the front cover. To achieve this object, the closing plate structure includes a closing plate provided at a rear lateral end with a rearward-extended bent retaining strip that provides a certain degree of resilience and has a free end forward projected from a front side of the closing plate. A user may conveniently remove and replace the closing plate simply by operating the free end of the bent retaining strip, and peripherals for a computer may be conveniently installed into or dismounted from the computer case via the opening on the front cover behind the closing plate.

In the closing plate structure of the present invention, the bent retaining strip is so configured that it provides a restoring force after being operated.

Moreover, the closing plate of the present invention is provided at another rear lateral end with a rearward extended catch that is provided at a lateral outer surface with a hooking projection for directly engaging with a recess provided on the front cover to fix the closing plate to the front panel.

The structure and the technical means adopted by the present invention to achieve the above and other objects can be best understood by referring to the following detailed description of the preferred embodiments and the accompanying drawings, wherein
Fig. 1 is a front exploded perspective view showing the closing plate structure for front cover of computer case according to the present invention;
Fig. 2 a rear exploded perspective view of Fig. 1;
Fig. 3 is an enlarged rear perspective view of a closing plate included in the present invention viewed from a first side thereof;
Fig. 4 is an enlarged rear perspective view of the closing plate included in the present invention viewed from a second side thereof; and
Figs. 5 to 7 shows movements of removing and replacing the closing plate of the present invention from and to the front cover of the computer case.

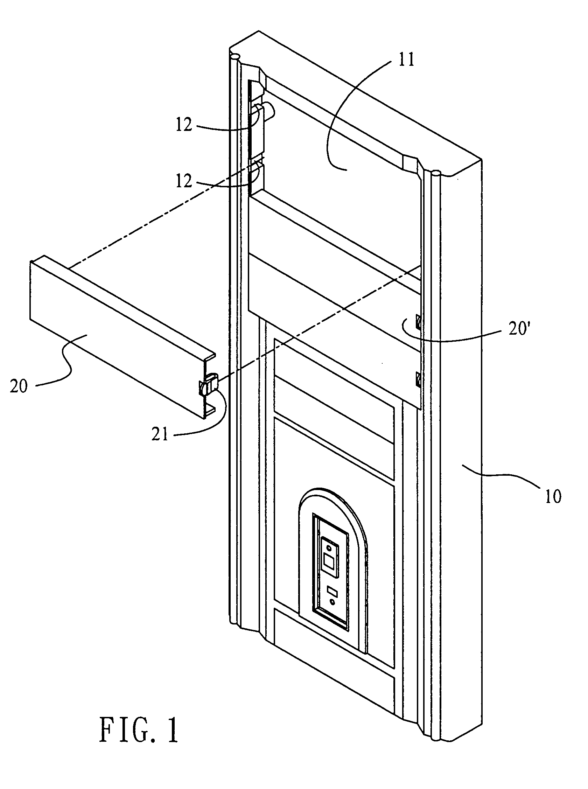

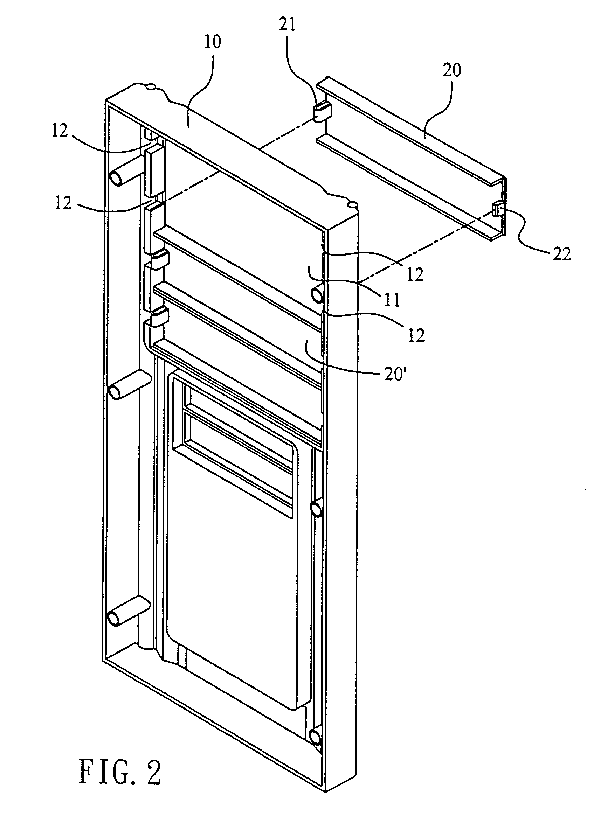

Please refer to Figs. 1 and 2 that are front and rear exploded perspective views, respectively, showing a closing plate structure for a front cover 10 of a computer case according to the present invention. The closing plate structure is characterized in that a closing plate 20 thereof may be removed from and replaced to the front cover 10 directly from a front side of the front cover 10.

The front cover 10 includes an opening 11, into which at least one closing plate 20 may be mounted. The opening 11 is provided at two lateral walls with at least one pair of recesses 12.

The closing plate 20 is a rectangular plate having first and second catches 21, 22 rearward extended from two rear lateral ends of the closing plate 20 for engaging with the two recesses 12 on the front cover 10, so that the closing plate 20 may be fixed in the opening 11 to close a predetermined portion of the opening 11, as indicated by the reference number 20' in Fig. 2.

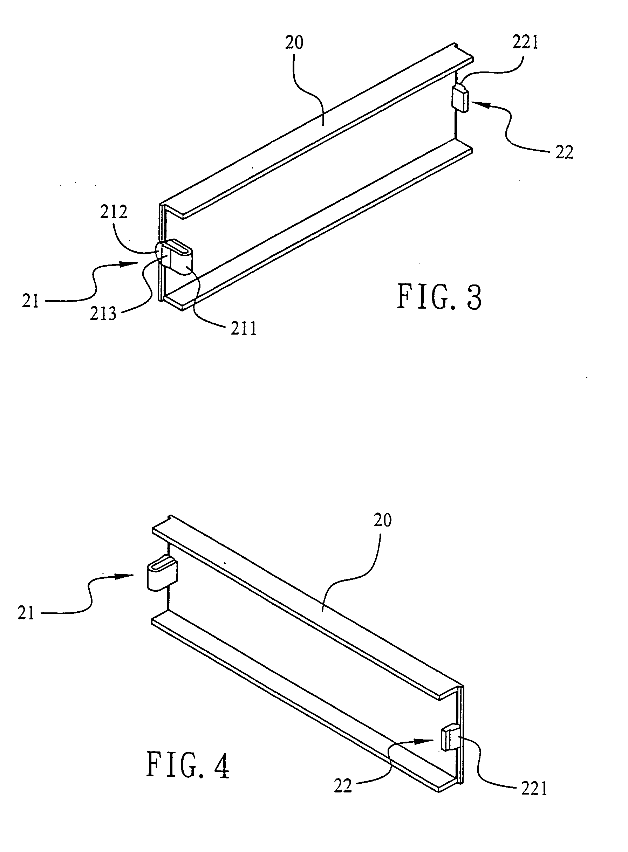

Please refer to Figs. 3 and 4 that are rear perspective views of the closing plate 20 viewed from two different angles. The first and the second catch 21, 22 provided at two rear lateral ends of the closing plate 20 are differently structured. The first catch 21 includes a U-shaped retaining strip 211 extended from one rear lateral end of the closing plate 20 with a free end 212 of the U-shaped retaining strip 211 projected from a front side of the closing plate 20 (see also Fig. 1) , so that a user may access to and operate the free end 212 from the front side of the closing plate 20. A lateral outer surface of the U-shaped retaining strip 211 is formed into a hooking projection 213 adapted to fitly engage with and be held at the recess 12 on the front cover 10. The second catch 22 is rearward extended from the other rear lateral end of the closing plate 20 and also formed at a lateral outer surface with a hooking projection 221 for engaging with the recess 12 on the front cover 10.

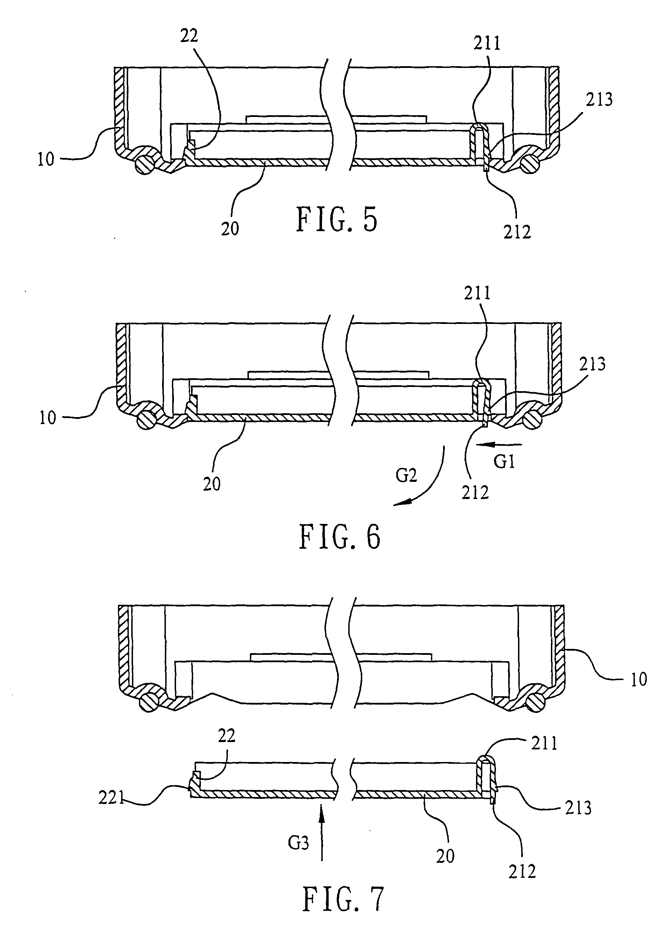

Please refer to Figs. 5, 6, and 7. Fig. 5 shows the closing plate 20 is mounted in the opening 11 on the front cover 10 with the first and the second catch 21, 22 at two rear lateral ends of the closing plate 20 separately engaging with the two recesses 12 on the lateral walls of the opening 11. The U-shaped retaining strip 211 of the first catch 21 provides a restoring force for the hooking projection 213 at the lateral outer surface of the first catch 21 to firmly press against the recess 12.

To remove the closing plate 20 from the front cover 10, first apply a push against the free end 212 of the U-shaped retaining strip 211 of the first catch 21 in a direction indicated by the arrow G1 in Fig. 6, so that the retaining strip 211 is deformed and the hooking projection 213 is disengaged from the recess 12, allowing the closing plate 20 to be turned in a direction indicated by the arrow G2 in Fig. 6 and moved out of the opening 11. At this point, the second catch 22 is also disengaged from the other recess 12, allowing the user to remove the whole closing plate 20 from the front cover 10 directly from a front side of the front cover 10.

On the other hand, when it is desired to replace the closing plate 20 to the front cover 10, simply push the closing plate 20 toward the front cover 10 as indicated by the arrow G3 in Fig. 7. When the U-shaped retaining strip 211 of the first catch 21 passes the lateral wall of the opening 11, it is pushed by the lateral wall and deformed, allowing the hooking projections 213, 221 on the first and second catches 21, 22, respectively, to pass through the opening 11 and engage with the recesses 12 to fit on the front cover 10 again, as shown in Fig. 5.

With the above closing plate structure, a user may easily remove and replace the closing plate 20 from and to the front cover 10. It is no need to dismount the front cover 10 from the computer case or disassemble the computer case. The closing plate structure of the present invention is therefore particularly suitable for a computer case of a desktop computer system having removable peripherals connected thereto.

The present invention has been described with a preferred embodiment thereof and it is understood that many changes and modifications in the described embodiment, such as providing the catches on the front cover and the recesses on the closing plate, can be carried out without departing from the scope and the spirit of the invention that is intended to be limited only by the appended claims.

## Claims

1. A closing plate structure for front cover of computer case, comprising:
a front cover for mounting to a front side of a computer case, said front cover being formed of an opening, and said opening being provided at two lateral walls with at least one pair of recesses; and
at least one closing plate having a rectangular configuration, said closing plate being provided at two rear lateral ends with two rearward extended catches, said catches being adapted to detachably engage with said pair of recesses provided at two lateral wall of said opening on said front cover and thereby hold said closing plate thereto;
at least one of said two catches on said closing plate being resilient and having a free end forward proj ected from a front side of said closing plate, such that said closing plate may be removed or replaced from or to said front cover at the front side of said front cover through operating said forward projected free end of said catch.

2. The closing plate structure for front cover of computer case as claimed in claim 1, wherein said two rearward extended catches at two rear lateral ends of said closing plate are first and second catches, said first catch being a U-shaped retaining strip having a free end projected from a front side of said closing plate, and wherein said U-shaped retaining strip is formed at a lateral outer surface with a hooking projection adapted to detachably engage with said recess on said front cover.

3. The closing plate structure for front cover of computer case as claimed in claim 2, wherein said second catch is rearward extended from the other rear lateral end of said closing plate, and provided at a lateral outer surface with a hooking projection adapted to detachably engage with said recess on said front cover.
